(19) Europäisches Patentamt
European Patent Office
Office européen des brevets

(11) **EP 3 646 045 B1**

(12) **FASCICULE DE BREVET EUROPEEN**

(45) Date de publication et mention
de la délivrance du brevet:
**26.07.2023   Bulletin 2023/30**

(21) Numéro de dépôt: **18733577.3**

(22) Date de dépôt: **20.06.2018**

(51) Classification Internationale des Brevets (IPC):
***G01R 31/11*** *(2006.01)*

(52) Classification Coopérative des Brevets (CPC):
**G01R 31/11**

(86) Numéro de dépôt international:
**PCT/EP2018/066461**

(87) Numéro de publication internationale:
**WO 2019/002056 (03.01.2019 Gazette 2019/01)**

(54) **SYSTEME DE REFLECTOMETRIE POUR L'ANALYSE DE DEFAUTS DANS UNE LIGNE DE TRANSMISSION**

REFLEKTOMETRISCHES SYSTEM ZUR FEHLERANALYSE IN EINER ÜBERTRAGUNGSLEITUNG

REFLECTOMETRY SYSTEM FOR ANALYSING FAULTS IN A TRANSMISSION LINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **30.06.2017   FR 1756097**

(43) Date de publication de la demande:
**06.05.2020   Bulletin 2020/19**

(73) Titulaire: **Commissariat à l'Énergie Atomique et aux Énergies Alternatives**
**75015 Paris (FR)**

(72) Inventeurs:
• **CABANILLAS, Esteban**
**91400 Orsay (FR)**
• **LAYER, Christophe**
**75015 Paris (FR)**

(74) Mandataire: **Atout PI Laplace**
**Immeuble "Visium"**
**22, avenue Aristide Briand**
**94117 Arcueil Cedex (FR)**

(56) Documents cités:
EP-A2- 2 293 454          WO-A1-2016/050547
US-A1- 2001 005 402     US-A1- 2009 153 132
US-A1- 2017 153 283

**Description**

L'invention concerne le domaine des systèmes de diagnostic filaire basés sur le principe de la réflectométrie. Elle concerne plus précisément un tel système dans lequel est intégré un amplificateur du signal à injecter dans la ligne de transmission à analyser. L'invention vise à proposer une solution permettant de compenser l'effet non linéaire induit par un amplificateur sur le signal à injecter.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts qui impactent ces câbles, ces informations incluant l'existence de défauts mais aussi leur localisation et leur type. L'analyse de défauts permet d'aider à la maintenance des câbles. Les méthodes de réflectométrie usuelles permettent ce type d'analyse.

Les méthodes de réflectométrie utilisent un principe proche de celui du radar : un signal électrique, le signal de sonde ou signal de référence, est injecté en un ou plusieurs endroits du câble à tester. Le signal se propage dans le câble ou le réseau de câbles et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention entre dans le champ d'application des méthodes de diagnostic filaire par réflectométrie et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Un problème à résoudre dans un système de diagnostic filaire concerne l'atténuation que subit le signal injecté dans le câble à analyser, lorsqu'il se propage le long de ce câble jusqu'à rencontrer un point de réflexion. Lorsque le câble est long par rapport à la longueur d'onde du signal, celui-ci subit une atténuation lors de sa propagation et de sa rétro-propagation, qui est fonction de la distance parcourue par le signal. Cette atténuation présente un inconvénient majeur lors de l'étape d'analyse des signaux réfléchis qui vise à identifier un pic d'amplitude dans le résultat de l'inter-corrélation entre le signal émis et le signal réfléchi. En effet, plus le signal est atténué, plus il est difficile de détecter la signature d'un défaut dans la mesure du signal réfléchi. Ceci est d'autant plus vrai que le défaut visé est un défaut non franc, c'est-à-dire qui correspond à une faible rupture d'impédance, c'est-à-dire un défaut superficiel.

Par ailleurs, l'atténuation du signal dépend également de sa fréquence, elle est d'autant plus importante que la fréquence du signal est élevée. Or, pour localiser un défaut de petite taille avec une précision suffisante, il est bien souvent nécessaire d'utiliser un signal à haute fréquence, car plus la fréquence est élevée, plus la résolution de détection et localisation du défaut sera améliorée.

Pour limiter l'atténuation du signal lors de sa propagation dans un câble, il est donc souhaitable d'utiliser un amplificateur pour amplifier le signal avant son injection, afin de limiter les effets de l'atténuation.

Cependant, les amplificateurs de signaux ont un comportement non-linéaire qui entraine une saturation des valeurs élevées du signal à amplifier. Ce comportement non-linéaire est d'autant plus présent que le signal à amplifier présente un rapport entre puissance crête et puissance moyenne (ou PAPR pour Peak to Average Power Ratio) élevé. C'est le cas notamment pour des signaux multi-porteuses comme les signaux OFDM (Orthogonal Frequency Division Multiplexing), MCTDR (Multi-Carrier Time Domain Reflectometry) ou OMTDR (Orthogonal Multi-carrier Time Domain Reflectometry) qui sont couramment utilisés dans les systèmes de réflectométrie. L'effet non-linéaire d'un amplificateur est également du à une sélectivité en fréquence du comportement des différents composants de l'amplificateur.

Ce comportement non linéaire dégrade le rapport signal sur bruit des mesures réalisées et engendre un étalement du spectre du signal. La dégradation du rapport signal sur bruit a un effet néfaste sur la précision de la détection des défauts, tandis que l'étalement du spectre entraine des problèmes d'occupation, par le signal injecté dans le câble, de bandes de fréquences interdites car destinées à un autre usage.

L'invention vise à proposer une solution permettant de corriger l'effet non linéaire d'un amplificateur tout en limitant l'encombrement général du dispositif de réflectométrie qui est destiné à être embarqué dans un équipement portatif.

Une première solution pour compenser l'effet non linéaire d'un amplificateur consiste à réaliser une pré-distorsion du signal à amplifier en prélevant une fraction du signal de sortie de l'amplificateur et en la renvoyant vers le générateur de signal. Ce signal rétro-alimenté permet d'estimer la fonction à appliquer au signal à générer, avant son injection, pour compenser l'effet non linéaire de l'amplificateur. Cette fonction de correction est, par exemple, déterminée à partir d'une combinaison linéaire de séries de Volterra ou de polynômes orthogonaux. Les documents [1] et [2] donnent deux exemples de détermination d'une fonction de pré-distorsion d'un signal.

Un inconvénient de cette méthode est qu'elle nécessite une boucle de correction au niveau du générateur de signal qui implique d'ajouter des composants supplémentaires dans le système, en particulier un convertisseur analogique-numérique supplémentaire pour convertir le signal en sortie de l'amplificateur avant de le renvoyer vers le module chargé de calculer la fonction de pré-distorsion. L'ajout de composants supplémentaires présente l'inconvénient d'un encombrement et d'une consommation plus importants pour le système résultant.

Une autre solution consiste à réaliser une post-distorsion du signal amplifié avant son injection dans le câble. La post-distorsion consiste à éliminer l'interférence non-linéaire en réception. Cela est fait, par exemple, à partir de filtres non-linéaires réalisés, comme dans le cas de la pré-distorsion, à partir des séries de Volterra ou de polynômes orthogonaux. Cette technique permet seulement de corriger l'interférence non-linéaire mais est sans effet sur l'étalement spectral. En outre, l'estimation de paramètres de post-distorsion est moins précise à cause du rapport signal à bruit en réception, normalement bien plus dégradé que celui en transmission.

On connait par ailleurs d'autres solutions décrites dans les documents EP2293454, US2017/153283, US2009/153132, WO2016/050547 et US 2001/005402.

L'invention propose un système de réflectométrie comprenant un amplificateur du signal à injecter dans le câble à analyser et qui intègre un mécanisme de correction de l'effet non linéaire de l'amplificateur sans augmenter significativement l'encombrement du système en limitant le nombre de composants supplémentaires à intégrer par rapport à un système sans correction de l'effet non linéaire.

L'invention a ainsi pour objet un système de réflectométrie pour l'analyse de défauts dans une ligne de transmission, comprenant :

- Un générateur de signal numérique,
- Un premier convertisseur pour convertir le signal numérique en un signal analogique,
- Un amplificateur du signal analogique,
- Un moyen pour injecter le signal amplifié dans la ligne de transmission,
- Un moyen pour prélever le signal rétro-propagé dans la ligne de transmission,
- Un second convertisseur pour convertir le signal prélevé en signal numérique, une sortie de l'amplificateur étant reliée à une entrée du second convertisseur,
- Un dispositif de pré-distorsion du signal à générer, configuré pour calculer une fonction de compensation de l'effet non linéaire de l'amplificateur et appliquer la fonction de compensation au signal à générer, la fonction de compensation étant calculée au moins à partir du signal mesuré en sortie du second convertisseur,
- Un premier dispositif de connexion/déconnexion reliant une sortie de l'amplificateur et une entrée du moyen pour injecter le signal amplifié, le premier dispositif de connexion/déconnexion étant apte à être commandé en position ouverte pendant une première phase de calibration du signal pendant laquelle la fonction de compensation est calculée et en position fermée pendant une seconde phase d'injection du signal calibré dans la ligne de transmission,
- Un corrélateur pour corréler le signal numérique généré et le signal numérique obtenu en sortie du second convertisseur.

Dans une variante de réalisation particulière, le système selon l'invention comprend un second dispositif de connexion/déconnexion reliant une sortie de l'amplificateur et une entrée du second convertisseur, le second dispositif de connexion/déconnexion étant apte à être commandé en position fermée pendant la première phase de calibration du signal.

Selon un aspect particulier de l'invention, le second dispositif de connexion/déconnexion est apte à être commandé en position ouverte pendant la seconde phase d'injection du signal calibré dans la ligne de transmission.

Selon un aspect particulier de l'invention, le dispositif de pré-distorsion est disposé entre une sortie du second convertisseur et une entrée du générateur de signal.

Selon un aspect particulier de l'invention, le système selon l'invention comprend un organe de décision configuré pour estimer, pendant la phase de calibration, un niveau de distorsion du signal en sortie de l'amplificateur, dû à l'effet non linéaire de l'amplificateur, et commander le premier dispositif de connexion/déconnexion et/ou le second dispositif de connexion/déconnexion en fonction du niveau de distorsion estimé pour activer la phase d'injection du signal dans la ligne de transmission.

Selon un aspect particulier de l'invention, l'organe de décision comprend un moyen pour évaluer le spectre fréquentiel du signal en sortie du second convertisseur et estimer le niveau de distorsion du signal en fonction d'au moins une caractéristique du spectre fréquentiel évalué.

Selon un aspect particulier de l'invention, le niveau de distorsion est estimé en comparant la largeur du spectre fréquentiel évalué avec une largeur de spectre fréquentiel attendue.

Selon un aspect particulier de l'invention, le corrélateur comprend un dispositif de calcul d'une transformée de Fourier et ledit moyen pour évaluer le spectre fréquentiel du signal comprend ledit dispositif de calcul d'une transformée de Fourier.

Selon un aspect particulier de l'invention, le système selon l'invention comprend un atténuateur disposé entre une sortie de l'amplificateur et une entrée du second convertisseur.

Selon un aspect particulier de l'invention, le système selon l'invention comprend un dispositif de contrôle automatique de gain disposé entre le moyen pour prélever le signal rétro-propagé et le second convertisseur.

Selon un aspect particulier de l'invention, le moyen pour injecter un signal dans la ligne de transmission et le moyen pour prélever le signal rétro-propagé sont réalisés par un premier coupleur directif.

Selon un aspect particulier de l'invention, le système selon l'invention comprend un second coupleur directif disposé entre le moyen pour prélever le signal rétro-propagé et une entrée du second convertisseur, et agencé pour relier une sortie de l'amplificateur à une entrée du second convertisseur.

Selon un aspect particulier de l'invention, le système selon l'invention comprend un dispositif d'analyse du résultat produit par le corrélateur pour analyser la présence de défaut sur la ligne de transmission.

D'autres caractéristiques et avantages de la présente invention apparaîtront mieux à la lecture de la description qui suit en relation aux dessins annexés qui représentent :

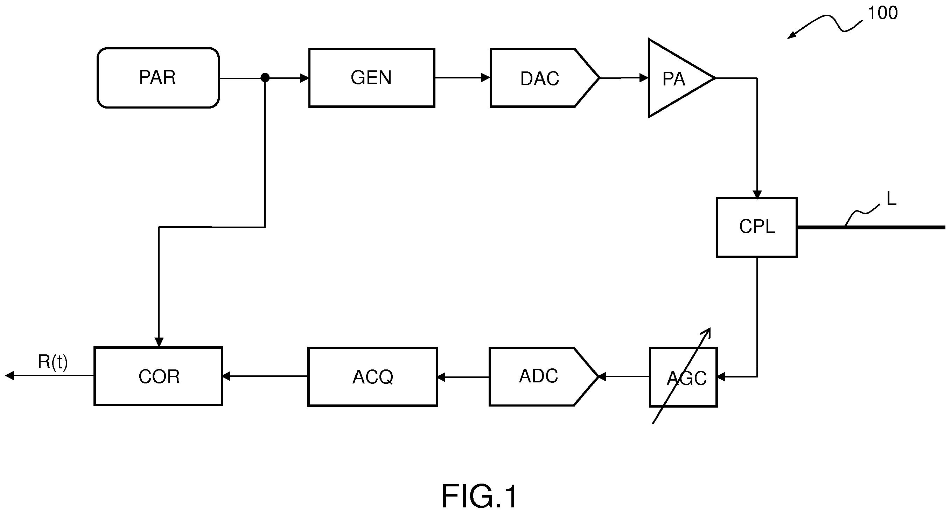

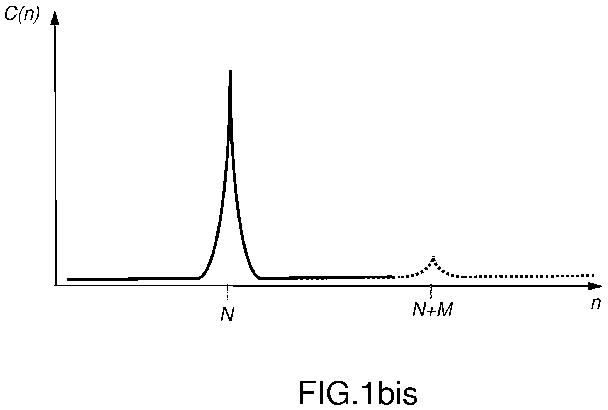

- La figure 1, un schéma d'un système de réflectométrie intégrant un amplificateur du signal à injecter dans une ligne de transmission,
- La figure 1 bis, un exemple de réflectogramme obtenu avec un système de réflectométrie n'intégrant pas d'amplificateur,
- La figure 2, un schéma d'un système de réflectométrie modifié selon l'invention pour compenser l'effet non linéaire de l'amplificateur de signal,
- La figure 3, un schéma d'un système de réflectométrie selon une variante de réalisation de l'invention.

La figure 1 représente un schéma d'un système 100 d'analyse de défauts dans une ligne de transmission L, par réflectométrie temporelle intégrant un calcul d'inter-corrélation entre le signal injecté dans la ligne et le signal mesuré après sa rétro-propagation dans la ligne.

Un tel système comprend principalement un générateur GEN d'un signal de référence à partir de paramètres PAR définissant la forme d'onde du signal. Le signal de référence numérique généré est converti analogiquement via un convertisseur numérique-analogique DAC, est amplifié par un amplificateur PA, par exemple un amplificateur de puissance, puis est injecté en un point de la ligne de transmission L au moyen d'un coupleur directionnel CPL. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit totalement ou partiellement sur la discontinuité d'impédance provoquée par le défaut. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Un dispositif de contrôle automatique de gain AGC permet d'ajuster l'amplitude du signal à la dynamique du convertisseur analogique numérique ADC. Une acquisition ACQ est réalisée en effectuant, par exemple, une moyenne du signal sur plusieurs périodes. Une corrélation COR est ensuite effectuée entre le signal numérique mesuré et une copie du signal numérique généré avant injection afin de produire un réflectogramme temporel R(t) correspondant à l'intercorrélation entre les deux signaux.

Comme cela est connu dans le domaine des méthodes de diagnostic par réflectométrie temporelle, la position $d_{DF}$ d'un défaut sur le câble L, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut non franc.

La figure 1 bis représente un exemple de réflectogramme C(n) obtenu sans utiliser d'amplificateur PA, sur lequel on observe un premier pic d'amplitude à une abscisse N et un second pic d'amplitude à une abscisse N+M. Le premier pic d'amplitude correspond à la réflexion du signal au point d'injection dans le câble, tandis que le second pic correspond à la réflexion du signal sur une discontinuité provoquée par un défaut non franc. On remarque que l'amplitude du second pic est fortement atténuée du fait de l'absence d'amplificateur.

Différentes méthodes connues sont envisageables pour déterminer la position $d_{DF}$ du défaut sur le câble. Une première méthode consiste à appliquer la relation liant distance et temps : $d_{DF} = V_g \cdot t_{DF}$ où $V_g$ est la vitesse de propagation du signal dans le câble. Une autre méthode possible consiste à appliquer une relation de proportionnalité du type $d_{DF}/t_{DF} = L_c/t_0$ où $L_c$ est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

Ainsi, à partir de l'analyse du réflectogramme R(t), il est possible d'en déduire des informations sur la présence et la localisation de défauts.

La fonction de transfert d'un amplificateur de puissance PA peut être approximée à partir d'un polynôme d'ordre N. A titre illustratif, on considère une fonction de transfert basée sur un polynôme d'ordre égal à 5 :

$$y_n = a_1 x_n + a_3 x_n^3 + a_5 x_n^5$$

Dans l'équation précédente, $x_n$ représente le signal en entrée de l'amplificateur PA et $y_n$ représente le signal en sortie de l'amplificateur PA. Les valeurs des coefficients de la fonction de transfert dépendent du degré de saturation de l'amplificateur de puissance PA.

Lorsque le signal amplifié par l'amplificateur de puissance PA subit une distorsion, cela entraine un élargissement ou un étalement du spectre du signal. Cet étalement spectral résulte de la multiplication du signal $x_n$ par lui-même lors de son amplification, ce qui équivaut à une convolution dans le domaine spectral. Par exemple, le terme $x_n^3$ dans la fonction de transfert précitée induit une composante spectrale avec une bande trois fois plus large dans le signal que la bande de fréquence occupée par le signal avant amplification $x_n$. Le niveau de cette composante spectrale est déterminé par le facteur $a_3$, qui est une fonction du degré de saturation de l'amplificateur PA.

Un problème additionnel dû au comportement non-linéaire de l'amplificateur PA concerne l'interférence non-linéaire. Cela vient du fait que la non-linéarité est combinée aux fonctions filtrantes mises en oeuvre par les différents composants du système de réflectométrie. Par exemple, le générateur de signal GEN peut comprendre un filtre de mise en forme. Le convertisseur numérique-analogique DAC, le coupleur directif CPL et le convertisseur analogique-numérique ADC présentent également des fonctions de transferts qui peuvent s'apparenter à des filtres. Ces filtres peuvent être représentés par des combinaisons linéaires des échantillons numériques à injecter. Le filtre est, par exemple, représenté par la relation suivante :

$$x_n = \sum_{i=0}^{M} b_i s_{n-i}$$

L'interférence non-linéaire est le résultat de la combinaison des fonctions linéaires mises en oeuvre par les différents composants du système avec la fonction non-linéaire caractérisant l'amplificateur PA.

L'implémentation d'un dispositif permettant de linéariser un amplificateur PA qui travaille dans sa zone de saturation est très coûteux en termes de ressources matérielles. Un tel dispositif implique généralement une boucle de rétroaction au niveau du transmetteur. Cette boucle est composée essentiellement d'un coupleur, d'un atténuateur et d'un convertisseur analogique-numérique de haute précision, travaillant au moins à la même vitesse que le convertisseur numérique-analogique du système de réflectométrie. Cet encombrement matériel, qui peut représenter jusqu'à 50% de l'encombrement analogique supplémentaire, est trop important dans le contexte d'un système de réflectométrie bas cout ou basse consommation ou tout simplement embarqué.

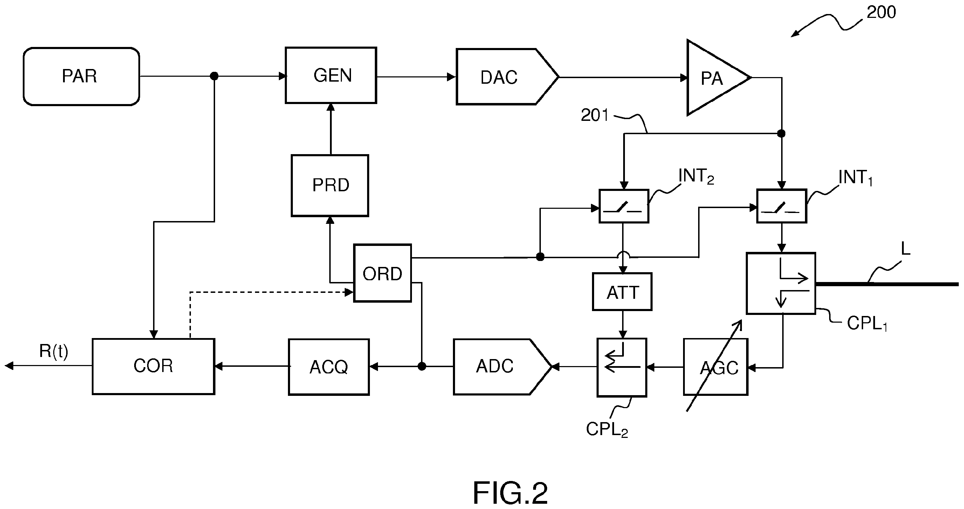

La figure 2 représente un schéma d'un système 200 d'analyse de défauts dans une ligne de transmission L, selon l'invention. Plus généralement, le système 200 est adapté pour mettre en oeuvre une technique de détection et/ou localisation de défauts par réflectométrie.

Le système 200 présente un fonctionnement en deux phases successives, une première phase de calibration au cours de laquelle le signal généré est corrigé pour prendre en compte l'effet non linéaire de l'amplificateur PA, puis une seconde phase de traitement au cours de laquelle le signal est injecté dans la ligne de transmission L et une analyse par réflectométrie est appliquée sur le signal rétro-propagé et prélevé au point d'injection.

Le système 200 comprend les mêmes éléments déjà décrits à la figure 1, à savoir un générateur de signal GEN, un convertisseur numérique-analogique DAC, un amplificateur PA, un premier coupleur directif $CPL_1$ pour injecter le signal dans la ligne de transmission L et prélever le signal rétro-propagé, un dispositif de contrôle automatique de gain AGC, un convertisseur analogique-numérique ADC, un module d'acquisition ACQ et un corrélateur COR.

Le système 200 comprend en outre un module de pré-distorsion PRD configuré pour corriger le signal généré afin de compenser l'effet non linéaire de l'amplificateur PA. Le module de pré-distorsion est agencé entre le générateur de signal GEN et la sortie du convertisseur analogique numérique ADC.

Le système 200 comprend également un premier interrupteur $INT_1$ positionné sur le chemin entre la sortie de l'amplificateur PA et le premier coupleur directif $CPL_1$. Lorsque l'interrupteur $INT_1$ est en position ouverte, le signal en sortie de l'amplificateur PA n'est pas injecté dans la ligne de transmission L. Lorsque l'interrupteur $INT_1$ est en position fermée, le signal en sortie de l'amplificateur PA est injecté dans la ligne de transmission L.

Le système 200 comprend également une connexion 201 entre la sortie de l'amplificateur PA et l'entrée du convertisseur analogique-numérique ADC. Cette connexion 201 est, par exemple, réalisée au moyen d'un second coupleur directif CPL$_2$ positionné entre le dispositif de contrôle automatique de gain AGC et le convertisseur analogique numérique ADC. Dans un premier mode de réalisation de l'invention, cette connexion 201 peut être permanente. Dans un second mode de réalisation de l'invention, un second interrupteur INT$_2$ peut être positionné sur cette connexion 201. Lorsque le second interrupteur INT$_2$ est en position fermée, le signal de sortie de l'amplificateur PA est injecté directement en entrée du convertisseur analogique numérique ADC.

Le premier interrupteur INT$_1$ et/ou le second interrupteur INT$_2$ peuvent être remplacés par tout dispositif de connexion/déconnexion équivalent, par exemple un commutateur. La connexion 201 et/ou la connexion entre l'amplificateur PA et le coupleur directif CPL$_1$ peut aussi être réalisée manuellement par connexion/déconnexion des liaisons respectives.

Dans un mode de réalisation de l'invention, un atténuateur ATT est positionné sur le chemin de la connexion 201 pour ramener l'amplitude du signal, qui a été amplifié par l'amplificateur PA, dans la dynamique du convertisseur analogique numérique ADC. L'atténuateur ATT permet de ne pas éblouir le convertisseur analogique numérique ADC. Dans un mode de réalisation particulier, il peut être fusionné avec le second coupleur directif CPL$_2$.

Le système 200 comprend également un organe de décision ORD pour commander le premier interrupteur INT$_1$ et, optionnellement, le second interrupteur INT$_2$ en fonction d'une estimation du niveau de distorsion du signal amplifié en sortie de l'amplificateur PA, la distorsion étant due à l'effet non linéaire de l'amplificateur PA.

Le fonctionnement du système 200 selon l'invention est le suivant. Dans une première phase de calibration, le premier interrupteur INT$_1$ est commandé en position ouverte par l'organe de décision ORD. Si le second interrupteur INT$_2$ est présent, il est commandé en position fermée par l'organe de décision ORD.

Le générateur GEN génère un signal numérique qui est converti analogiquement puis amplifié par l'amplificateur PA. Le signal amplifié traverse la connexion 201 pour arriver en entrée du convertisseur analogique numérique. Il est au préalable éventuellement atténué si un atténuateur est présent sur le chemin 201. Le signal est converti numériquement puis est transmis au module de pré-distorsion PRD qui estime une fonction corrective à appliquer au signal à générer pour corriger l'effet non linéaire de l'amplificateur PA et obtenir un signal amplifié avec un niveau de distorsion diminué. Le module de pré-distorsion PRD implémente, par exemple, une fonction qui modélise un système non-linéaire, par exemple une fonction construite à partir d'une combinaison linéaire des séries de Volterra. Une telle fonction est appliquée sur le signal à générer pour le modifier afin de compenser l'effet non-linéaire de l'amplificateur PA.

La fonction correctrice à appliquer par le module de pré-distorsion PRD pour compenser l'effet non linéaire de l'amplificateur PA peut être modélisée à partir de la relation suivante :

$$\mathbf{s}'_\mathbf{n} = \sum_{i=0}^{M} \mathbf{q_i s_{n+i}} + \sum_{i=0}^{M}\sum_{j=0}^{M} \mathbf{q_{i,j} s_{n+i} s_{n+j}} + \sum_{i=0}^{M}\sum_{j=0}^{M}\sum_{k=0}^{M} \mathbf{q_{i,j,k} s_{n+i} s_{n+j} s_{n+k}} + \cdots$$

Dans cette équation, les échantillons $\mathbf{s_{n+i}}$ représentent le signal numérique généré avant pré-distorsion et $\mathbf{s'_n}$ représente le signal $s_n$ corrigé par la fonction de pré-distorsion. Les coefficients $\mathbf{q_i}$ représentent les paramètres de la fonction correctrice. Les coefficients $\mathbf{q_i}$ peuvent être déterminés par une méthode de réduction de l'erreur carrée, comme la méthode LMS (least-mean squares) ou RLS (récursive least squares) ou toute autre méthode équivalente. L'ensemble des paramètres $\mathbf{q_i}$ optimal est celui qui minimise l'erreur $\|s_n - r_n\|^2$, où $r_n$ représente le signal en sortie du convertisseur analogique numérique ADC et $\| \|^2$ représente la fonction module élevé au carré. On détermine ainsi les coefficients de la fonction de pré-distorsion de sorte à minimiser l'erreur entre le signal en sortie de l'amplificateur PA (mesuré en sortie du convertisseur ADC) et le signal généré $s_n$ avant pré-distorsion, c'est-à-dire le signal non distordu par l'effet de l'amplificateur PA.

Une autre façon de modéliser le système consiste à utiliser une série de polynômes orthogonaux. Dans ce cas, le signal en sortie de l'amplificateur est modélisé par la relation suivante :

$$\mathbf{s}'_\mathbf{n} = \sum_{i=0}^{M} \mathbf{q_i P^{(i)}(s_n)}$$

$\mathbf{q_i}$ sont des coefficients de la fonction de pré-distorsion et $\mathbf{P}^{(i)}(\cdot)$ est un polynôme orthogonal d'ordre i. L'Homme du métier peut implémenter le calcul de la fonction de pré-distorsion à partir des indications données dans les références [1] ou [2] ou en utilisant toute autre méthode alternative connue ayant pour but de corriger a priori le signal à générer en fonction d'une évaluation du niveau de distorsion impactant le signal en sortie de l'amplificateur PA.

Dans un mode de réalisation de l'invention, le calcul de la fonction de pré-distorsion et la correction du signal à générer peuvent faire l'objet d'une ou plusieurs itérations. Autrement dit, lorsque le signal généré a été corrigé une première fois par le module de pré-distorsion, l'interrupteur $INT_1$ peut être maintenu en position fermée pour réaliser une nouvelle itération de calcul de la fonction de pré-distorsion.

Dans un mode de réalisation de l'invention, l'organe de décision ORD mesure à chaque itération le niveau de distorsion obtenu sur le signal prélevé en sortie du convertisseur analogique numérique ADC et décide, lorsque le niveau de distorsion est acceptable, de commander l'interrupteur $INT_1$ en position fermée pour arrêter la phase de calibration et démarrer la phase d'analyse.

Dans un mode de réalisation particulier de l'invention, l'évaluation du niveau de distorsion du signal est effectuée en calculant une information de rapport signal à bruit.

Dans un autre mode de réalisation de l'invention, l'évaluation du niveau de distorsion du signal est effectuée en déterminant le spectre fréquentiel du signal en sortie du convertisseur analogique numérique ADC et en comparant ce spectre au spectre du signal attendu en l'absence de distorsion. En particulier, la largeur du spectre peut être utilisée comme caractéristique de comparaison. En effet, l'effet non linéaire de l'amplificateur PA engendre un étalement du spectre du signal amplifié (comme expliqué précédemment). Donc, une augmentation de la largeur du spectre du signal amplifié par rapport au signal attendu donne une indication du niveau de distorsion.

Dans un mode de réalisation particulier de l'invention, le spectre fréquentiel du signal est déterminé en utilisant un module de transformée de Fourier présent au sein du corrélateur COR. En effet, le corrélateur COR est implémenté en réalisant une transformée de Fourier discrète du signal mesuré, une transformée de Fourier discrète du signal de référence puis un produit des deux résultats puis enfin une transformée de Fourier discrète inverse du résultat du produit. Cette implémentation résulte de la formule suivante exprimant l'intercorrélation de deux signaux x(t) et x'(t) :

$$c(t) = \int_{-\infty}^{\infty} x'(t+\tau) \cdot x^*(\tau) \mathrm{d}\tau = \mathrm{TF}^{-1}\left\{\mathrm{TF}\left\{x'(t)\right\} \cdot \mathrm{TF}\left\{x^*(t)\right\}\right\}$$

Ainsi, le corrélateur COR comprend déjà un module de calcul de transformée de Fourier discrète qui est, avantageusement, utilisé par l'organe de décision ORD pour déterminer le spectre fréquentiel du signal.

A la fin de la phase de calibration, c'est-à-dire lorsque le niveau de distorsion mesuré sur le signal en sortie du convertisseur analogique numérique est suffisamment bas, l'organe de décision commande le premier interrupteur $INT_1$ en position fermée pour que le signal amplifié soit injecté dans la ligne de transmission L via le coupleur $CPL_1$.

Le signal rétro-propagé est prélevé par le coupleur $CPL_1$ et transmis le long de la chaine de traitement jusqu'au corrélateur. Lors de la phase d'analyse, le second interrupteur $INT_2$ peut être commandé en position ouverte ou en position fermée. S'il est en position fermée, alors le signal en entrée du convertisseur analogique numérique ADC résulte de la somme du signal prélevé par le coupleur $CPL_1$ et du signal transmis via la connexion 201. Dans un tel cas, le réflectogramme obtenu en sortie du corrélateur COR comprend un premier pic d'amplitude qui correspond au signal généré et transmis via la connexion 201 et éventuellement d'autres pics d'amplitude correspondant à des défauts de la ligne de transmission sur lesquels le signal est réfléchi. Le premier pic d'amplitude peut être utilisé comme référence pour estimer la distance entre le point d'injection du signal et un défaut éventuel. Ainsi, le second interrupteur $INT_2$ est rendu optionnel car le maintien de la connexion 201 pendant la phase d'analyse ne perturbe pas le fonctionnement du système d'analyse de défauts.

Pendant la phase d'analyse, l'estimation de la fonction de pré-distorsion est arrêtée mais le module de pré-distorsion PRD continue à corriger le signal généré avec la fonction de pré-distorsion estimée pendant la phase de calibration.

Dans un mode de réalisation particulier de l'invention, le système 200 peut être utilisé comme système de transmission de données via la ligne de transmission L. Dans ce cas, le signal généré n'est plus un signal stationnaire mais un signal quelconque qui véhicule des données à transmettre.

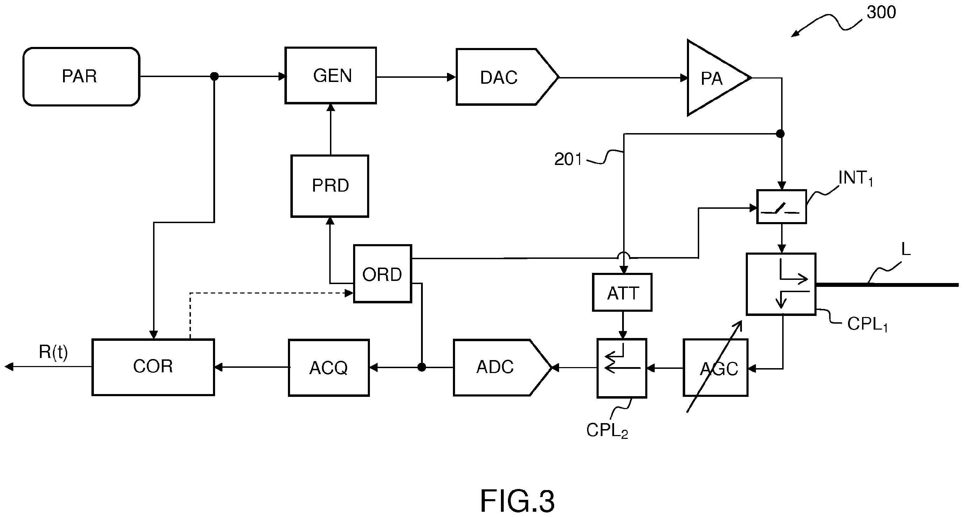

La figure 3 représente une variante 300 du système 200 dans lequel, comme expliqué ci-dessus, le second interrupteur $INT_2$ est rendu optionnel.

Le système selon l'une quelconque des variantes de réalisation de l'invention peut être mis en oeuvre par une carte électronique sur laquelle sont disposés les différents composants. La carte peut être connectée au câble à analyser par un moyen de couplage $CPL_1$ qui peut être un coupleur directionnel à effet capacitif ou inductif ou encore une connexion ohmique. Le dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

Les interrupteurs $INT_1, INT_2$ peuvent être réalisés à l'aide de tout composant apte à être commandé en position ouverte ou fermée pour ouvrir ou fermer une connexion entre deux composants. Ils peuvent par exemple prendre la forme de commutateurs ou tout autre composant équivalent.

En outre, une unité de traitement, de type ordinateur, assistant numérique personnel ou autre dispositif électronique ou informatique équivalent peut être utilisé pour piloter le système selon l'invention et afficher les résultats des calculs effectués par le corrélateur COR sur une interface homme-machine, en particulier le réflectogramme R(t) et/ou les informations de détection et localisation de défauts sur le câble.

Le procédé selon l'invention, en particulier les modules de traitement numérique GEN,PRD,ORD,ACQ,COR peuvent être implémentés dans un processeur embarqué ou non ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le système de réflectométrie selon l'invention peut comporter, au sein d'un même dispositif, à la fois les composants aptes à générer le signal de référence et à l'injecter dans une ou plusieurs ligne(s) de transmission et les composants aptes à mesurer le signal rétro-propagé et à réaliser les calculs nécessaires à l'élaboration d'un réflectogramme. Alternativement, ces deux parties peuvent être implémentées sur deux dispositifs distincts, chaque dispositif étant connecté indépendamment au câble à analyser.

L'invention présente l'avantage d'utiliser le convertisseur analogique numérique ADC présent de base dans tout système de réflectométrie pour l'intégrer à une boucle de pré-distorsion du signal à générer afin de compenser l'effet non linéaire de l'amplificateur PA.

Ainsi, l'encombrement global du système est limité car il ne nécessite que l'ajout de deux modules de traitement numérique PRD,ORD (qui peuvent être co-localisés dans un seul module) et d'un interrupteur $INT_1$.

L'invention permet de calibrer le signal à générer dans une première phase de calibration puis d'injecter le signal calibré dans la ligne de transmission L à analyser sans perturber le fonctionnement global du système.

Références

[1] "H. Qian, S. Yao, H. Huang and W. Feng, A Low-Complexity Digital Predistortion Algorithm for Power Amplifier Linearization, in IEEE Transactions on Broadcasting, vol. 60, no. 4, pp. 670-678, Dec. 2014"
[2] "Y. Liu, W. Pan, S. Shao and Y. Tang, A General Digital Predistortion Architecture Using Constrained Feedback Bandwidth for Wideband Power Amplifiers, in IEEE Transactions on Microwave Theory and Techniques, vol. 63, no. 5, pp. 1544-1555, May 2015"

**Revendications**

1. Système de réflectométrie (200,300) pour l'analyse de défauts dans une ligne de transmission (L), comprenant :

   - Un générateur (GEN) de signal numérique,
   - Un premier convertisseur (DAC) pour convertir le signal numérique en un signal analogique,
   - Un amplificateur (PA) du signal analogique,
   - Un moyen ($CPL_1$) pour injecter le signal amplifié dans la ligne de transmission,
   - Un moyen ($CPL_1$) pour prélever le signal rétro-propagé dans la ligne de transmission,
   - Un second convertisseur (ADC) pour convertir le signal prélevé en signal numérique, une sortie de l'amplificateur (PA) étant reliée à une entrée du second convertisseur (ADC),
   - Un dispositif (PRD) de pré-distorsion du signal à générer, configuré pour calculer une fonction de compensation de l'effet non linéaire de l'amplificateur (PA) et appliquer la fonction de compensation au signal à générer, la fonction de compensation étant calculée au moins à partir du signal mesuré en sortie du second convertisseur (ADC),
   - Un premier dispositif de connexion/déconnexion ($INT_1$) reliant une sortie de l'amplificateur (PA) et une entrée du moyen ($CPL_1$) pour injecter le signal amplifié, le premier dispositif de connexion/déconnexion ($INT_1$) étant apte à être commandé en position ouverte pendant une première phase de calibration du signal pendant laquelle la fonction de compensation est calculée et en position fermée pendant une seconde phase d'injection du signal calibré dans la ligne de transmission,
   - Un corrélateur (COR) pour corréler le signal numérique généré et le signal numérique obtenu en sortie du second convertisseur (ADC).

**2.** Système de réflectométrie selon la revendication 1 comprenant un second dispositif de connexion/déconnexion (INT$_2$) reliant une sortie de l'amplificateur (PA) et une entrée du second convertisseur (ADC), le second dispositif de connexion/déconnexion (INT$_2$) étant apte à être commandé en position fermée pendant la première phase de calibration du signal.

**3.** Système de réflectométrie selon la revendication 2 dans lequel le second dispositif de connexion/déconnexion (INT$_2$) est apte à être commandé en position ouverte pendant la seconde phase d'injection du signal calibré dans la ligne de transmission (L).

**4.** Système de réflectométrie selon l'une des revendications précédentes dans lequel le dispositif de pré-distorsion (PRD) est disposé entre une sortie du second convertisseur (ADC) et une entrée du générateur (GEN) de signal.

**5.** Système de réflectométrie selon l'une des revendications précédentes comprenant un organe de décision (ORD) configuré pour estimer, pendant la phase de calibration, un niveau de distorsion du signal en sortie de l'amplificateur (PA), dû à l'effet non linéaire de l'amplificateur (PA), et commander le premier dispositif de connexion/déconnexion (INT$_1$) et/ou le second dispositif de connexion/déconnexion (INT$_2$) en fonction du niveau de distorsion estimé pour activer la phase d'injection du signal dans la ligne de transmission.

**6.** Système de réflectométrie selon la revendication 5 dans lequel l'organe de décision (ORD) comprend un moyen pour évaluer le spectre fréquentiel du signal en sortie du second convertisseur (ADC) et estimer le niveau de distorsion du signal en fonction d'au moins une caractéristique du spectre fréquentiel évalué.

**7.** Système de réflectométrie selon la revendication 6 dans lequel le niveau de distorsion est estimé en comparant la largeur du spectre fréquentiel évalué avec une largeur de spectre fréquentiel attendue.

**8.** Système de réflectométrie selon l'une des revendications 6 ou 7 dans lequel le corrélateur (COR) comprend un dispositif de calcul d'une transformée de Fourier et ledit moyen pour évaluer le spectre fréquentiel du signal comprend ledit dispositif de calcul d'une transformée de Fourier.

**9.** Système de réflectométrie selon l'une des revendications précédentes comprenant un atténuateur (ATT) disposé entre une sortie de l'amplificateur (PA) et une entrée du second convertisseur (ADC).

**10.** Système de réflectométrie selon l'une des revendications précédentes comprenant un dispositif (AGC) de contrôle automatique de gain disposé entre le moyen (CPL$_1$) pour prélever le signal rétro-propagé et le second convertisseur (ADC).

**11.** Système de réflectométrie selon l'une des revendications précédentes dans lequel le moyen pour injecter un signal dans la ligne de transmission et le moyen pour prélever le signal rétro-propagé sont réalisés par un premier coupleur directif (CPL$_1$).

**12.** Système de réflectométrie selon l'une des revendications précédentes comprenant un second coupleur directif (CPL$_2$) disposé entre le moyen (CPL$_1$) pour prélever le signal rétro-propagé et une entrée du second convertisseur (ADC), et agencé pour relier une sortie de l'amplificateur (PA) à une entrée du second convertisseur (ADC).

**13.** Système de réflectométrie selon l'une des revendications précédentes comprenant un dispositif d'analyse du résultat produit par le corrélateur (COR) pour analyser la présence de défaut sur la ligne de transmission (L).

**Patentansprüche**

**1.** Reflektometersystem (200, 300) zum Analysieren von Fehlern in einer Übertragungsleitung (L), das Folgendes umfasst:

- einen Digitalsignalgenerator (GEN),
- einen ersten Wandler (DAC) zum Umwandeln des digitalen Signals in ein analoges Signal,
- einen Verstärker (PA) für das analoge Signal,

- ein Mittel (CPL$_1$) zum Einspeisen des verstärkten Signals in die Übertragungsleitung,
- ein Mittel (CPL$_1$) zum Abgreifen des über die Übertragungsleitung rückpropagierten Signals,
- einen zweiten Wandler (ADC) zum Umwandeln des abgegriffenen Signals in ein digitales Signal, wobei ein Ausgang des Verstärkers (PA) mit einem Eingang des zweiten Wandlers (ADC) verbunden ist,
- eine Vorrichtung (PRD) zum Vorverzerren des zu erzeugenden Signals, die zum Berechnen einer Kompensationsfunktion für den nichtlinearen Effekt des Verstärkers (PA) und zum Anwenden der Kompensationsfunktion auf das zu erzeugende Signal konfiguriert ist, wobei die Kompensationsfunktion mindestens auf der Basis des am Ausgang des zweiten Wandlers (ADC) gemessenen Signals berechnet wird,
- eine erste Verbindungs-/Trennvorrichtung (INT$_1$), die einen Ausgang des Verstärkers (PA) und einen Eingang des Mittels (CPL$_1$) zum Einspeisen des verstärkten Signals verbindet, wobei die erste Verbindungs-/Trennvorrichtung (INT$_1$) während einer ersten Signalkalibrationsphase, in der die Kompensationsfunktion berechnet wird, in eine offene Position, und während einer zweiten Phase des Einspeisens des kalibrierten Signals in die Übertragungsleitung in eine geschlossene Position gesteuert werden kann,
- einen Korrelator (COR) zum Korrelieren des erzeugten digitalen Signals und des am Ausgang des zweiten Wandlers (ADC) erhaltenen digitalen Signals.

2. Reflektometriesystem nach Anspruch 1, das eine zweite Verbindungs-/Trennvorrichtung (INT$_2$) umfasst, die einen Ausgang des Verstärkers (PA) und einen Eingang des zweiten Wandlers (ADC) verbindet, wobei die zweite Verbindungs-/Trennvorrichtung (INT$_2$) während der ersten Signalkalibrationsphase in eine geschlossene Position gesteuert werden kann.

3. Reflektometriesystem nach Anspruch 2, wobei die zweite Verbindungs-/Trennvorrichtung (INT$_2$) während der zweiten Phase des Einspeisens des kalibrierten Signals in die Übertragungsleitung (L) in die offene Position gesteuert werden kann.

4. Reflektometriesystem nach einem der vorhergehenden Ansprüche, wobei die Vorverzerrungsvorrichtung (PRD) zwischen einem Ausgang des zweiten Wandlers (ADC) und einem Eingang des Signalgenerators (GEN) angeordnet ist.

5. Reflektometriesystem nach einem der vorhergehenden Ansprüche, das eine Entscheidungseinheit (ORD) umfasst, die zum Schätzen, während der Kalibrierungsphase, eines Verzerrungsniveaus des Signalausgangs vom Verstärker (PA) aufgrund des nichtlinearen Effekts des Verstärkers (PA) und zum Steuern der ersten Verbindungs-/Trennvorrichtung (INT$_1$) und/oder der zweiten Verbindungs-/Trennvorrichtung (INT$_2$) in Abhängigkeit von dem geschätzten Verzerrungsniveau konfiguriert ist, um die Phase der Signaleinspeisung in die Übertragungsleitung zu aktivieren.

6. Reflektometriesystem nach Anspruch 5, wobei die Entscheidungseinheit (ORD) ein Mittel zum Bewerten des Frequenzspektrums des Signals am Ausgang des zweiten Wandlers (ADC) und zum Schätzen des Verzerrungsniveaus des Signals in Abhängigkeit von mindestens einer Charakteristik des bewerteten Frequenzspektrums umfasst.

7. Reflektometriesystem nach Anspruch 6, wobei das Verzerrungsniveau durch Vergleichen der Breite des bewerteten Frequenzspektrums mit einer erwarteten Breite des Frequenzspektrums geschätzt wird.

8. Reflektometriesystem nach Anspruch 6 oder 7, wobei der Korrelator (COR) eine Vorrichtung zum Berechnen einer Fourier-Transformation umfasst und das Mittel zum Bewerten des Frequenzspektrums des Signals die Vorrichtung zum Berechnen einer Fourier-Transformation umfasst.

9. Reflektometriesystem nach einem der vorhergehenden Ansprüche, das einen Dämpfer (ATT) umfasst, der zwischen einem Ausgang des Verstärkers (PA) und einem Eingang des zweiten Wandlers (ADC) angeordnet ist.

10. Reflektometriesystem nach einem der vorhergehenden Ansprüche, das eine Vorrichtung (AGC) zur automatischen Verstärkungsregelung umfasst, die zwischen dem Mittel (CPL$_1$) zum Abgreifen des rückpropagierten Signals und dem zweiten Wandler (ADC) angeordnet ist.

11. Reflektometriesystem nach einem der vorhergehenden Ansprüche, wobei das Mittel zum Einspeisen eines Signals in die Übertragungsleitung und das Mittel zum Abgreifen des rückpropagierten Signals durch einen ersten Richtkoppler (CPL$_1$) realisiert sind.

12. Reflektometriesystem nach einem der vorhergehenden Ansprüche, das einen zweiten Richtkoppler (CPL$_2$) umfasst,

der zwischen dem Mittel (CPL$_1$) zum Abgreifen des rückpropagierten Signals und einem Eingang des zweiten Wandlers (ADC) angeordnet und zum Verbinden eines Ausgangs des Verstärkers (PA) mit einem Eingang des zweiten Wandlers (ADC) ausgelegt ist.

13. Reflektometriesystem nach einem der vorhergehenden Ansprüche, das eine Vorrichtung zum Analysieren des vom Korrelator (COR) erzeugten Ergebnisses umfasst, um die Übertragungsleitung (L) auf Fehler zu analysieren.


**Claims**

1. A reflectometry system (200, 300) for analysing faults in a transmission line (L), comprising:

   - a digital-signal generator (GEN),
   - a first converter (DAC) for converting the digital signal into an analogue signal,
   - an amplifier (PA) of the analogue signal,
   - a means (CPL$_1$) for injecting the amplified signal into the transmission line,
   - a means (CPL$_1$) for sampling the signal propagated back through the transmission line,
   - a second converter (ADC) for converting the sampled signal into a digital signal, an output of the amplifier (PA) being connected to an input of the second converter (ADC),
   - a device (PRD) for predistorting the signal to be generated, configured to compute a function for compensating for the non-linear effect of the amplifier (PA) and to apply the compensation function to the signal to be generated, the compensation function being computed at least from the signal measured at the output from the second converter (ADC),
   - a first connecting/disconnecting device (INT$_1$) connecting an output of the amplifier (PA) and an input of the means (CPL$_1$) for injecting the amplified signal, the first connecting/disconnecting device (INT$_1$) being able to be controlled to open position during a first phase of calibrating the signal, during which phase the compensation function is computed, and to closed position during a second phase of injecting the calibrated signal into the transmission line,
   - a correlator (COR) for correlating the generated digital signal and the digital signal obtained as output from the second converter (ADC).

2. The reflectometry system according to claim 1, comprising a second connecting/disconnecting device (INT$_2$) connecting an output of the amplifier (PA) and an input of the second converter (ADC), the second connecting/disconnecting device (INT$_2$) being able to be controlled to closed position during the first phase of calibrating the signal.

3. The reflectometry system according to claim 2, wherein the second connecting/disconnecting device (INT$_2$) is able to be controlled to open position during the second phase of injecting the calibrated signal into the transmission line (L).

4. The reflectometry system according to one of the preceding claims, wherein the predistorting device (PRD) is placed between an output of the second converter (ADC) and an input of the signal generator (GEN).

5. The reflectometry system according to one of the preceding claims, comprising a deciding unit (ORD) configured to estimate, during the calibrating phase, a level of distortion of the signal output from the amplifier (PA), due to the non-linear effect of the amplifier (PA), and to control the first connecting/disconnecting device (INT$_1$) and/or the second connecting/disconnecting device (INT$_2$) depending on the estimated level of distortion to activate the phase of injecting the signal into the transmission line.

6. The reflectometry system according to claim 5, wherein the deciding unit (ORD) comprises a means for evaluating the frequency spectrum of the signal output from the second converter (ADC) and estimating the level of distortion of the signal depending on at least one characteristic of the evaluated frequency spectrum.

7. The reflectometry system according to claim 6, wherein the level of distortion is estimated by comparing the width of the evaluated frequency spectrum with an expected frequency-spectrum width.

8. The reflectometry system according to one of claims 6 or 7, wherein the correlator (COR) comprises a device for computing a Fourier transform and said means for evaluating the frequency spectrum of the signal comprises said device for computing a Fourier transform.

9. The reflectometry system according to one of the preceding claims, comprising an attenuator (ATT) placed between an output of the amplifier (PA) and an input of the second converter (ADC).

10. The reflectometry system according to one of the preceding claims, comprising a device (AGC) for automatically controlling gain, placed between the means (CPL$_1$) for sampling the back-propagated signal and the second converter (ADC)

11. The reflectometry system according to one of the preceding claims, wherein the means for injecting a signal into the transmission line and the means for sampling the back-propagated signal are performed by a first directional coupler (CPL$_1$).

12. The reflectometry system according to one of the preceding claims, comprising a second directional coupler (CPL$_2$) placed between the means (CPL$_1$) for sampling the back-propagated signal and an input of the second converter (ADC), and arranged to connect an output of the amplifier (PA) to an input of the second converter (ADC).

13. The reflectometry system according to one of the preceding claims, comprising a device for analysing the result produced by the correlator (COR) to analyse the presence of faults on the transmission line (L).

100

L

PA

DAC

GEN

PAR

CPL

AGC

ADC

ACQ

COR

R(t)

FIG.1

FIG.1bis

FIG.2

EP 3 646 045 B1

FIG.3

## RÉFÉRENCES CITÉES DANS LA DESCRIPTION

**Documents brevets cités dans la description**

- EP 2293454 A
- US 2017153283 A
- US 2009153132 A
- WO 2016050547 A
- US 2001005402 A

**Littérature non-brevet citée dans la description**

- **H. QIAN ; S. YAO ; H. HUANG ; W. FENG.** A Low-Complexity Digital Predistortion Algorithm for Power Amplifier Linearization. *IEEE Transactions on Broadcasting,* Décembre 2014, vol. 60 (4), 670-678
- **Y. LIU ; W. PAN ; S. SHAO ; Y. TANG.** A General Digital Predistortion Architecture Using Constrained Feedback Bandwidth for Wideband Power Amplifiers. *IEEE Transactions on Microwave Theory and Techniques,* Mai 2015, vol. 63 (5), 1544-1555